# EUROPÄISCHE PATENTSCHRIFT

(11) **EP 0 710 369 B1**
(45) Veröffentlichungstag und Bekanntmachung des Hinweises auf die Patenterteilung: **05.07.2000**
(21) Anmeldenummer: 95919413.5
(22) Anmeldetag: 05.05.1995
(51) Int. Cl.: G02B 17/08, G03F 7/20

(54) **HÖCHSTAPERTURIGES KATADIOPTRISCHES REDUKTIONSOBJEKTIV FÜR DIE MIKROLITHOGRAPHIE**
VERY WIDE APERTURE CATADIOPTRIC REDUCING OBJECT LENS FOR MICROLITHOGRAPHY
OBJECTIF REDUCTEUR CATADIOPTRIQUE A TRES GRANDE OUVERTURE S'UTILISANT EN MICROLITHOGRAPHIE

(30) Priorität: 19.05.1994 DE 4417489
(43) Veröffentlichungstag der Anmeldung: 08.05.1996
(73) Patentinhaber: Carl Zeiss, 89518 Heidenheim (Brenz) (DE)
(72) Erfinder: FÜRTER, Gerd, D-73479 Ellwangen (DE)
(86) Internationale Anmeldenummer: EP9501719
(87) Internationale Veröffentlichungsnummer: WO9532446

(56) Entgegenhaltungen:
- EP-A- 0 350 955
- US-A- 5 052 763
- US-A- 5 212 593
- US-A- 5 289 312

## Beschreibung

Die Erfindung betrifft ein katadioptrisches Reduktionsobjektiv mit Hohlspiegel, Strahlteilerfläche und mehreren Linsengruppen.

Bei einem derartigen Objektiv nach DE 42 03 464 ist die Systemblende am Ort des Hohlspiegels, auf der diesem zugekehrten Ein- und Austrittsfläche des Strahlteilers oder im Raum zwischen diesen angeordnet. Das gleiche gilt für EP 0 341 385, EP 0 350 955, EP 0 465 882 und EP 0 554 994. Bei derartigen Anordnungen liegt die höchste erreichbare numerische Apertur bei brauchbarer Bildqualität bei 0,60.

Bei der gattungsgemäßen Anordnung nach DE 41 10 296 ist die Blende an der Strahlteilerfläche des Strahlteilers angeordnet, wobei dieser reticleseitig in Transmission und waferseitig in Reflexion benutzt wird. Die Folgen sind:
- Die Blende ist nicht mehr variabel.
- Die elliptisch geformte Blende steht sehr schräg (ca. 45°) zur optischen Achse. Verschiedene Bildhöhen mit variierenden Hauptstrahlwinkeln an der Blende benutzen unterschiedlich große Blendenöffnungen, was zu Kontrast-, Telezentrie- und Intensitätsvariationen führt.

Aus US 5,289,312 ist ein katadioptrisches Reduktions-Projektionsobjektiv bekannt, das
- eine erste Linsengruppe;
- einen teildurchlässigen (schrägstehenden) Spiegel auf einer Planplatte oder in einem Strahlteiler;
- einen Konkavspiegel;
- eine zerstreuende zweite Linsengruppe zwischen den beiden Spiegeln;
- eine dritte Linsengruppe mit positiver Brechkraft am Schluß des Lichtwegs zur Bilderzeugung; und
- eine Blende zwischen dem teildurchlässigen Spiegel und der dritten Linsengruppe aufweist.

Die Ausführung mit Strahlteiler ist nur im Anspruch 11 angegeben, sonst nicht beschrieben. Die numerische Apertur des einzigen Beispiels beträgt lediglich 0,45. Zur Achromatisierung sind abwechselnd Quarz und Flußspat kombiniert. Der teildurchlässige Spiegel wird zuerst in Reflexion, danach in Transmission benutzt.

Ein Strahlteiler im Sinne dieser Anmeldung hat eine zwischen zwei Prismen angeordnete Strahlteilerfläche, also einen teildurchlässigen Spiegel, wie ein Strahlteilerwürfel.

Aufgabe der Erfindung ist es, ein katadioptrisches Reduktionsobjektiv mit einer möglichen numerischen Apertur von deutlich größer als 0,60 zu realisieren, bei dem die Systemblende hinter der Strahlteilerfläche liegen soll.

Vorzugsweise sollen die Hauptstrahl- und Randstrahlwinkel am Strahlteiler klein genug sein, um einen Polarisations-Strahlteiler zu ermöglichen. Außerdem soll das Objektiv vorzugsweise bildseitig telezentrisch sein. Darüber hinaus soll der Strahlteiler unter diesen Rahmenbedingungen möglichst klein sein.

Gelöst wird diese Aufgabe durch ein katadioptrisches Reduktionsobjektiv mit den Merkmalen des Anspruches 1.

Besonders vorteilhafte Ausführungsformen zeigen zudem Merkmale der Unteransprüche 2 bis 18.

Verwendung findet ein solches Objektiv zur mikrolithographischen Projektion mit bildseitigen Strukturen im Submikronbereich und ist dazu in einen mikrolithographischen Projektionsapparat eingebaut.

Folgende Figuren zeigen :
- Fig. 1a: einen Linsenschnitt eines katadioptrischen Reduktionsobjektivs für welches kein Schutz begehrt wird;
- Fig. 1b: einen vergrößerten Ausschnitt von Fig. la, allerdings mit vertauschter Abfolge von Reflexion und Transmission am Strahlteiler;
- Fig. 2: schematisch einen mikrolithographischen Projektionsapparat.

Dargestellt wird die Erfindung mit einem Ausführungsbeispiel gemäß der Zeichnung
- Fig. 3: Linsenschnitt eines katadioptrischen Reduktionsobjektivs mit Systemblende innerhalb der dritten Linsengruppe.

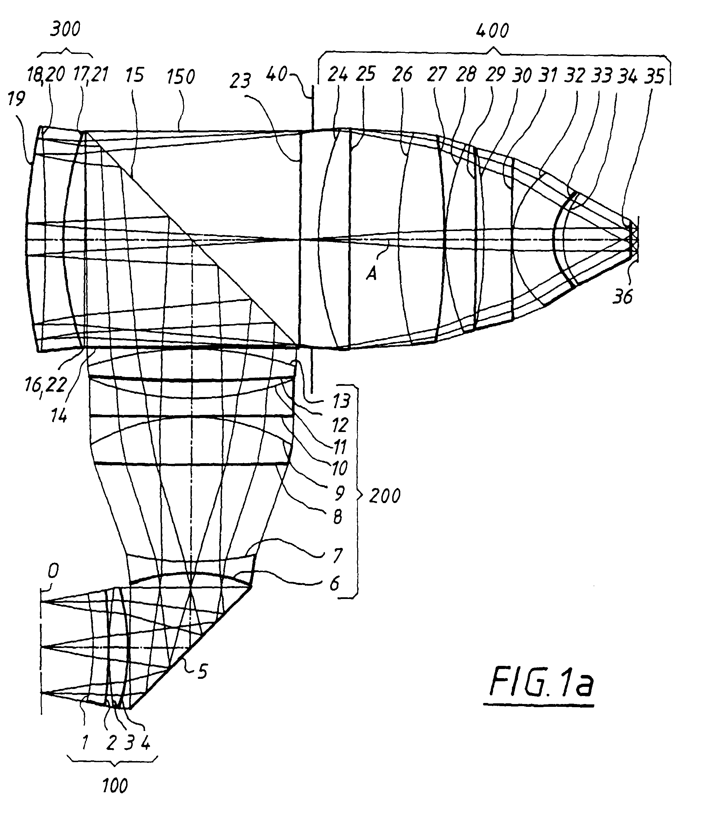

Figur 1a zeigt ein Beispiel eines 4:1 Reduktionsobjektivs für die Mikrolithographie für welches kein Schutz begehrt wird mit den drei Linsengruppen 100 mit 200, 300, 400, der Strahlteilerfläche 15 im Strahlteiler 150 und mit dem Hohlspiegel 19. Die Objektebene - für das Reticle - liegt bei 0, die Bildebene - für den Wafer - bei 36. Ein Umlenkspiegel 5 zwischen dem ersten 100 und zweiten Teil 200 der ersten Linsengruppe dient üblicherweise einem kompakteren Aufbau und erlaubt parallele Lagerung von Reticle und Wafer. Von dieser Umlenkung und der Aufteilung der ersten Linsengruppe 100, 200 kann jedoch auch abgesehen werden. Tabelle 1 gibt die Radien und Abstände aller optisch wirksamen Flächen 1 bis 35. Glasart ist einheitlich Quarz. Die Strahlteilerfläche 15 ist diagonal im Strahlteilerwürfel 150 mit den Grenzflächen 14 (Eintritt), 16 bzw. 22 (Aus- und Eintritt spiegelseitig) und 23 (Austritt bildseitig) angeordnet.

Dieses Beispiel ist ausgelegt für die Wellenlänge 248,38 nm. Es ist beidseitig telezentrisch mit Hauptstrahlwinkeln unter 0,2°. Der freie Arbeitsabstand ist 40 mm (0-1) reticleseitig und 6 mm (35-36) waferseitig.

Die erreichte numerische Apertur ist NA = 0,70 bei einem Bildkreisdurchmesser von 20 mm.

Die die Apertur festlegende Systemblende 40 liegt waferseitig 17 mm vom Strahlteiler 150 (Austrittsfläche 23) entfernt. Soll abgeblendet und die Telezentrie im Waferraum (Objektebene 36) exakt gehalten werden, dann muß die Systemblende 40 beim Abblenden in Richtung Strahlteiler 150 (Austrittsfläche 23) bewegt werden. Der Grenzwert für die geschlossene Blende wäre die Austrittsfläche 23 des Strahlteilers 150.

Diese Verschiebung der Systemblende 40 beim Abblenden ist geboten, da der Systemteil davor bezüglich der Petzvalsumme stark überkorrigiert ist und diese Überkorrektion nur teilweise durch negative sphärische Pupillenaberration ausgeglichen wird.

Die Systemblende 40 kann sowohl als spezielles, auch verstellbares, Bauteil, als auch durch eine Linsenfassung oder einen Tubus verkörpert sein.

Die Strahlteilerfläche 15 wird in diesem Beispiel zuerst in Reflexion und dann in Transmission benutzt.

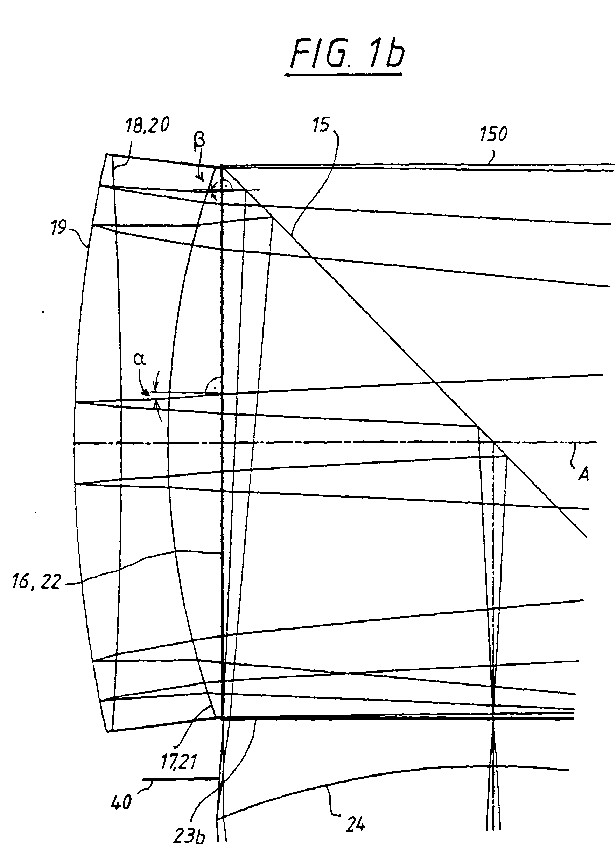

Fig. 1b zeigt einen Ausschnitt der Fig. la im Bereich des Hohlspiegels 19 und des Strahlteilers 150, jedoch mit vertauschter Reihenfolge von Transmission und Reflexion an der Strahlteilerfläche 15. Die Lage der ersten Linsengruppe 100, 200 und der dritten Linsengruppe 400 - mit der Linsenfläche 24 - einschließlich der Systemblende 40 wird also an der Strahlteilerfläche 15 gespiegelt, die Austrittsfläche 23b des Strahlteilers 150 tritt also an die Stelle der Eintrittsfläche 14 der Fig. la. Durch diese Maßnahme ragt der Hohlspiegel 19 nicht in die Reticleebene, was für die dort vorzusehenden Halte- und Verschiebeeinrichtungen mehr Freiheit läßt.

Figur 1b zeigt, daß die Hauptstrahlwinkel Alpha und die Randstrahlwinkel Beta am Strahlteilerwürfel 150 in Luft unter 5° liegen, der Randstrahlwinkel Beta am bildseitigen Ausgang sogar unter 4°. Im beschriebenen Beispiel sind die Randstrahlwinkel Beta bewußt in der Größenordnung der Hauptstrahlwinkel Alpha und divergent gehalten worden. Je größer die Hauptstrahlhöhen im Strahlteiler 150, desto geringer die Randstrahlhöhen und damit die Bündelquerschnitte. So lassen sich die Durchstoßhöhen der äußersten Komastrahlen im Strahlteilerwürfel 150 ungefähr konstant halten.

Die Strahlhöhen im Strahlteiler 150 sind also nirgends größer als am bildseitigen Ausgang 23 bzw. 23b, nahe dem Ort der Systemblende 40.

Dort aber sind die Strahlhöhen bzw. ist der Blendendurchmesser durch den vorgegebenen Lichtleitwert 0,70 x 20 = 14 und den gewählten Hauptstrahlwinkel von knapp 4,5° im wesentlichen festgelegt. Der Blendendurchmesser (40) und die Kantenlänge des 45°-Strahlteilerwürfels 150 sind ca. 190 mm.

Braucht die Polarisationsstrahlteilerfläche 15 aus belegungstechnischen Gründen in Reflexion oder Transmission besser kollimiertes Licht, so läßt sich dies zwar im Design berücksichtigen, geht aber zu Lasten der Durchmesser.

Die in Verbindung mit einer Polarisationsteilerfläche 15 erforderliche Lambda-Viertel-Schicht kann auf eine der Flächen 16 bis 19 aufgebracht sein oder zwischen den genannten Flächen als Folie oder Planplatte eingefügt sein.

Anstelle des Strahlteilerwürfels 150 ist eine schräg unter ca. 35° bis 60° stehende Strahlteilerplatte mit teildurchlässigem Spiegel ebenfalls brauchbar, vgl. US 5,289,312. Diese Ausführung erfordert für die Transmission möglichst kollimiertes Licht, was leichter erreichbar ist, wenn zuerst transmittiert und dann reflektiert wird.

Das vorliegende Design hat eine stark zerstreuende Linse 300 zwischen Strahlteilerfläche 15 und Hohlspiegel 19. Nur so läßt sich Licht mit kleinen Randstrahlwinkeln durch den Strahlteilerwürfel 150 führen, ohne daß die für eine ausreichende Korrekturwirkung notwendige Brechkraft des Spiegels 19 zu sehr reduziert wird.

Im Gegensatz zu den oben aufgeführten vorbekannten Objektiv-Konstruktionen (selbst zu DE 41 10 296) baut der waferseitge Objektivteil (dritte Linsengruppe 400) sehr lang. Besonders auffallend ist der große Luftraum zwischen den Flächen 25 und 26.

Bei bild-(wafer)seitiger Telezentrie liegt der vordere Hauptpunkt dieser Linsengruppe 400 um den Betrag der Brennweite hinter der Blende 40. Bei einer Bildhöhe von 10 mm und dem Hauptstrahlwinkel von knapp 4,5° ist die Brennweite 128 mm, der vordere Hauptpunkt also rund 128 mm von der Austrittsfläche 23 des Strahlteilers 150 entfernt. Der Abstand vom Strahlteiler 150 zum Bild 36 (Wafer) ist sogar deutlich größer als das Doppelte der Brennweite, bei diesem Beispiel das 2,2-fache (bei US 5,289,312 ist dieser Abstand etwa das 1,8-fache der Brennweite, bei DE 41 10 296 das 1,5-fache und bei allen anderen zitierten Anmeldungen ist er noch kleiner). Wird der Strahlteiler durch eine Strahlteilerplatte ersetzt, so ist hier statt des Abstands zum Strahlteiler der Abstand zu der der Austrittsfläche des Strahlteilers äquivalenten Fläche einzusetzen, die senkrecht zur optischen Achse ist und den teildurchlässigen Spiegel in einem Punkt gemeinsam mit dem Rand des Lichtbündels schneidet. Diese Maßnahme unterstützt die Anordnung der Systemblende 40 außerhalb des Strahlteilers 150.

Ansonsten besteht diese dritte Linsengruppe 400 aus stark sammelnden Untergruppen (24, 25), (26, 27), (28 - 31), (32 - 35), wobei zwischen den Flächen 29, 30 ein zerstreuender Luftraum zur Korrektion von sphärischer Aberration und Koma höherer Ordnung ist und zwischen den Flächen 33 und 34 ein zerstreuender Luftraum zur Korrektion von Verzeichnungen und Astigmatismus höherer Ordnung angeordnet ist.

Der objektseitige Objektivteil besteht aus einer ersten Linsengruppe mit zwei Teilen: Aus einem sammelnden Teil 100, bestehend aus zwei Linsen (1, 2), (3, 4), welcher u.a. die Telezentrizität besorgt, und aus einem zweiten Teil 200, bestehend aus der zerstreuenden Linse (6, 7) und aus der sammelnden Untergruppe mit den Flächen 8 bis 13 mit einem korrigierenden zerstreuenden Luftspalt zwischen den Flächen 11 und 12.

Ein Umlenkspiegel 5 zwischen dem ersten Teil 100 und dem zweiten Teil 200 ist optional und wird gewöhnlich vorgesehen, um eine kompakte Anordnung mit paralleler Lage von Reticle (Objektebene 0) und Wafer (Bildebene 36) zu erzielen.

Im Gegensatz zu den vorbekannten Objektiv-Konstruktionen baut dieser objektseitige Objektivteil, also die erste Linsengruppe 100, 200, sehr kurz.

Die Brennweite dieser ersten Linsengruppe 100, 200 ist wegen des Abbildungsmaßstabs des Gesamtobjektivs von 4:1 und wegen der brechkraftschwachen Kombination aus Linse 300 und Hohlspiegel 19 nahe beim 4-fachen der Brennweite der waferseitig (von der Blende 40) liegenden Linsengruppe 400, und zwar 556 mm. Die Brennweite dieses Objektivteils ist also relativ gering im Vergleich zur Schnittweite für den telezentrischen Hauptstrahl, nämlich dem Abstand der Linse (12, 13) zur Systemblende 40. Um dies zu erreichen, wirkt die stark zerstreuende Brechkraft der Linse (6, 7) zusammen mit der stark sammelnden Brechkraft der Untergruppe 8 bis 13 als Retrofokusaufbau. Vom Strahlteiler 150 aus zurückblickend wirkt dieser Aufbau als Tele-Aufbau mit entsprechend kurzer Schnittweite. Dementsprechend ist die Baulänge dieser ersten Linsengruppe 100, 200 (ca. 400 mm) deutlich kleiner als ihre Brennweite.

Die monochromatische Abbildungsgüte dieser Optik entspricht den Anforderungen der Mikrolithographie.

Der leistungsbegrenzende Farbfehler, die chromatische Längsaberration, ist weniger als halb so groß wie bei herkömmlichen reinen Linsen-Objektiven gleicher Spezifikation. Dieser Bildfehler läßt sich zusätzlich halbieren, wenn die 4 Sammellinsen (Untergruppen (24, 25), (26, 27), (28 - 31), (32 - 35)) hinter der Systemblende 40 statt aus Quarz aus Flußspat gefertigt werden. Durch Einführen von gelösten Quarz-Flußspat-Kittgliedern ließe sich die Achromatisierung noch weiter verbessern, bei allerdings stark erhöhtem Bauaufwand.

Dieses Beispiel umfaßt daher auch achromatisierte Objektive und läßt sich ebenso bei anderen Wellenlängen einsetzen.

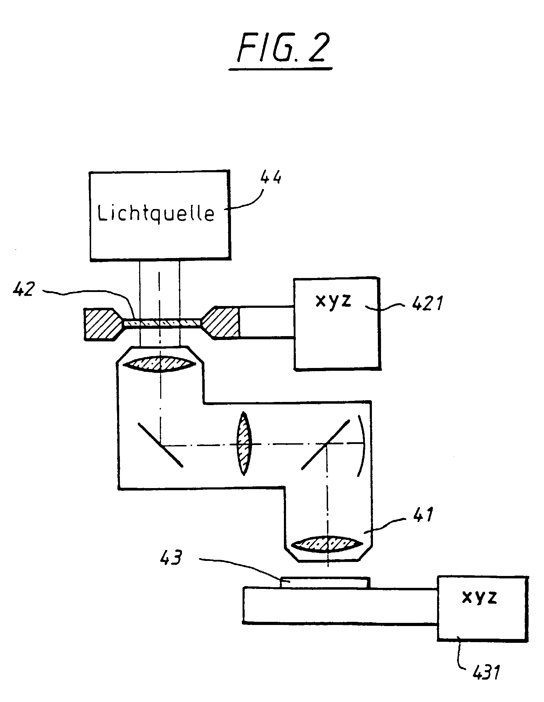

Figur 2 zeigt die Integration dieses katadioptrischen Reduktionsobjektivs 41 nach Figur la - der Strahlteilerwürfel ist allerdings durch eine Strahlteilerplatte ersetzt - in einem mikrolithographischen Projektionsapparat, bekannt als Wafer Stepper. In der Objektebene des Objektivs 41 ist ein Reticle 42 mit einer x-y-z-Positioniereinheit 421 positioniert. Das Reticle 42 wird mit Licht einer geeigneten Wellenlänge von einer Lichtquelle 44, z.B. einem Excimerlaser, beleuchtet. In der Bildebene des Objektivs 41 ist ein Wafer 43 mittels einer zweiten x-y-z-Positioniereinheit 431 angeordnet.

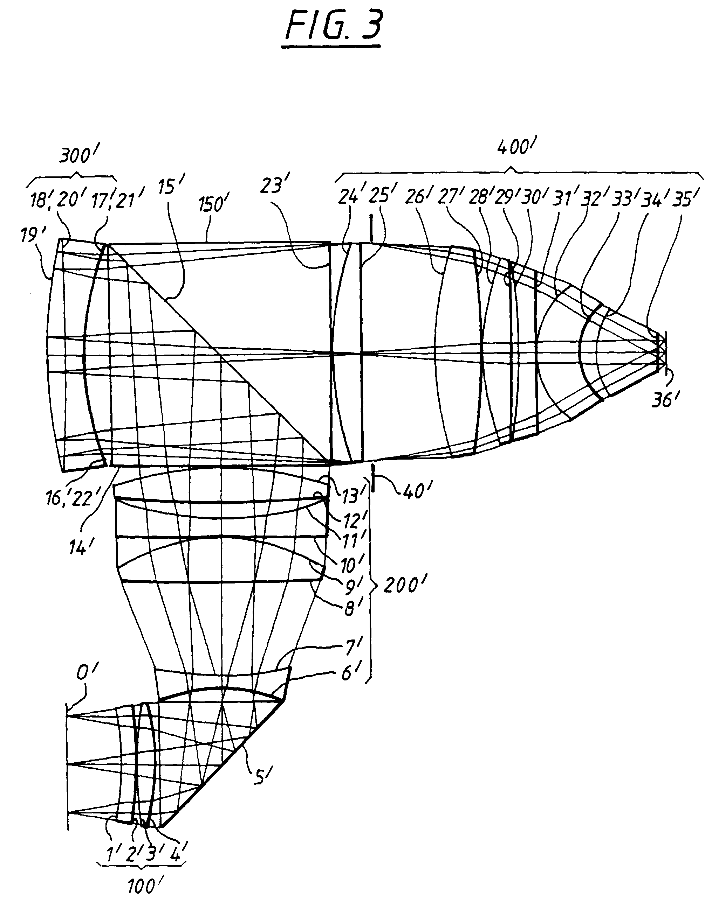

Das in Fig. 3 als Linsenschnitt dargestellte Ausführungsbeispiel der Erfindung mit den Daten der Tabelle 2 ist dem Beispiel nach Fig. la sehr ähnlich, hat jedoch die Systemblende 40' innerhalb der dritten Linsengruppe 400', und zwar nach deren erster Linse 24', 25', angeordnet. Die Systemblende 40' hat 8 mm Abstand vom Linsenscheitel der Fläche 25'.

Damit kann die Systemblende 40' unabhängig von der Blendenöffnung ortsfest bleiben ohne daß zu hohe Telezentrizitätsfehler entstehen, da die Sammellinse 24', 25' die Überkorrektion der Petzvalsumme vermindert und den Abstand der Systemblende 40' zum Hauptstrahlenschnittpunkt verringert.

Bei Wegfall der Verschiebeeinrichtung vermindert sich der Aufwand für Bau und Betrieb des Objektivs wesentlich. Da die Systemblende 40' auch wesentlich von den Elementen der ersten Linsengruppe 100', 200' abrückt, ist die Fassungskonstruktion weiter vereinfacht.

Es ist damit gezeigt, daß im Gegensatz zur Lehre der US 5,289,312 die Systemblende nicht nur in bestimmten Fällen zwischen der Strahlteilerfläche und der dritten Linsengruppe angeordnet werden kann, sondern daß ganz allgemein vorteilhafte Lösungen mit der Systemblende zwischen der Strahlteilerfläche und der Bildebene, insbesondere innerhalb der dritten Linsengruppe, erreicht werden können. Damit sind sehr große numerische Aperturen mit guter Korrektur bei unproblematischem Aufbau erreichbar.

Die vorstehend beschriebenen Beispiele haben den Abbildungsmaßstab -0,25. Andere in der Mikrolithographie sinnvolle Abbildungsmaßstäbe sind ebenfalls erfindungsgemäß realisierbar.

**Tabelle 1**

| Wellenlänge Lambda = 248,38 nm numerische Apertur NA = 0,70 Abbildungsmaßstab ß = - 0,25 Glas: Quarz n = 1,50834 | | | |
|---|---|---|---|
| Nr. | Radius | Dicke | Glas |
| | | 46,25 | |
| 1 | -210,36 | | |
| | | 13,36 | Quarz |
| 2 | -510,81 | | |
| | | 1,00 | |
| 3 | 360,18 | | |
| | | 16,63 | Quarz |
| 4 | -174,55 | | |
| | | 55,17 | |
| 5 | Plan | | |
| | | 66,00 | |
| 6 | -133,61 | | |
| | | 9,70 | Quarz |
| 7 | 274,40 | | |
| | | 85,10 | |
| 8 | 2016,25 | | |
| | | 41,88 | Quarz |
| 9 | -173,29 | | |
| | | 1,04 | |
| 10 | Plan | | |
| | | 15,60 | Quarz |
| 11 | 251,70 | | |
| | | 14,80 | |
| 12 | 1004,4 | | |
| | | 28,71 | Quarz |
| 13 | -282,11 | | |
| | | 1,01 | |
| 14 | Plan | | |
| | | 95,50 | Quarz |
| 15 | Plan | | |
| | | 95,50 | Quarz |
| 16 | Plan | | |
| | | 18,47 | |
| 17 | -280,11 | | |
| | | 16,14 | Quarz |
| 18 | 1577,8 | | |
| | | 16,10 | |
| 19 | -455,9 | Spiegel | |
| | | 16,10 | |
| 20 | -1578,0 | | |
| | | 16,14 | Quarz |
| 21 | 280,11 | | |
| | | 18,47 | |
| 22 | Plan | | |
| | | 191,0 | Quarz |
| 23 | Plan | | |
| | | 16,08 | |
| 24 | 269,14 | | |
| | | 26,98 | Quarz |
| 25 | 12084 | | |
| | | 44,08 | |
| 26 | 350,03 | | |
| | | 40,86 | Quarz |
| 27 | -596,96 | | |
| | | 1,01 | |
| 28 | 208,82 | | |
| | | 26,70 | Quarz |
| 29 | -2124,5 | | |
| | | 7,08 | |
| 30 | -436,19 | | |
| | | 24,52 | Quarz |
| 31 | 1966,2 | | |
| | | 1,01 | |
| 32 | 72,921 | | |
| | | 35,53 | Quarz |
| 33 | 51,743 | | |
| | | 9,02 | |
| 34 | 64,826 | | |
| | | 59,68 | Quarz |
| 35 | 2727.8 | | |
| | | 6,36 | |
| 36 | | | Bild (Wafer) |

**Tabelle 2**

| Wellenlänge Lambda = 248,38 nm numerische Apertur NA = 0,70 Abbildungsmaßstab ß = - 0,25 Glas: Quarz n = 1,50834 | | | |
|---|---|---|---|
| Nr. | Radius | Dicke | Glas |
| | | 46,25 | |
| 1 | -208,30 | | |
| | | 11,38 | Quarz |
| 2 | -498,48 | | |
| | | 1,00 | |
| 3 | 368,29 | | |
| | | 16,30 | Quarz |
| 4 | -173,64 | | |
| | | 55,82 | |
| 5 | Plan | | |
| | | 66,00 | |
| 6 | -127,78 | | |
| | | 9,70 | Quarz |
| 7 | 251,15 | | |
| | | 79,28 | |
| 8 | 1891,95 | | |
| | | 38,73 | Quarz |
| 9 | -160,51 | | |
| | | 1,03 | |
| 10 | -2818,18 | | |
| | | 15,49 | Quarz |
| 11 | 263,13 | | |
| | | 13,96 | |
| 12 | 997,93 | | |
| | | 29,30 | Quarz |
| 13 | -273,97 | | |
| | | 1,00 | |
| 14 | Plan | | |
| | | 95,50 | Quarz |
| 15 | Plan | | |
| | | 95,50 | Quarz |
| 16 | Plan | | |
| | | 21,10 | |
| 17 | -245,27 | | |
| | | 15,63 | Quarz |
| 18 | 3216,71 | | |
| | | 15,16 | |
| 19 | -437,42 | Spiegel | |
| | | 15,16 | |
| 20 | -3216,71 | | |
| | | 15,63 | Quarz |
| 21 | 245,27 | | |
| | | 21,10 | |
| 22 | Plan | | |
| | | 191,0 | Quarz |
| 23 | Plan | | |
| | | 1,00 | |
| 24 | 278,04 | | |
| | | 24,57 | Quarz |
| 25 | 4615,58 | | |
| | | 63,39 | |
| 26 | 262,26 | | |
| | | 40,81 | Quarz |
| 27 | -620,91 | | |
| | | 1,08 | |
| 28 | 208,55 | | |
| | | 24,75 | Quarz |
| 29 | -2336,21 | | |
| | | 6,67 | |
| 30 | -441,28 | | |
| | | 15,29 | Quarz |
| 31 | 1144,28 | | |
| | | 1,06 | |
| 32 | 71,95 | | |
| | | 36,07 | Quarz |
| 33 | 50,36 | | |
| | | 13,64 | |
| 34 | 60,47 | | |
| | | 53,85 | Quarz |
| 35 | 3672,41 | | |
| | | 6,34 | |
| 36 | | | Bild (Wafer) |

## Patentansprüche

1. Katadioptrisches Reduktionsobjektiv
- mit einer ersten Linsengruppe (100', 200'),
- mit einem teildurchlässigen Spiegel (15'),
- mit einer zweiten Linsengruppe (300'),
- mit einem Hohlspiegel (19'),
- mit einer dritten Linsengruppe (400') zwischen dem teildurchlässigen Spiegel (15') und der Bildebene (36'),
dadurch gekennzeichnet, daß
- die Systemblende (40') innerhalb der dritten Linsengruppe (400'),
vom teildurchlässigen Spiegel (15') her gesehen hinter der ersten Linse (24', 25') der dritten Linsengruppe (400') angeordnet ist.

2. Objektiv nach Anspruch 1 dadurch gekennzeichnet, daß die Position der Systemblende (40') unabhängig von der Öffnung im Bereich von der halben bis zur vollen Blendenzahl fest liegt, ohne Beeinträchtigung der Abbildungsqualität.

3. Objektiv nach mindestens einem der Ansprüche 1-2, dadurch gekennzeichnet, daß
der teildurchlässige Spiegel(15') in einem Strahlteiler (150') angeordnet ist.

4. Objektiv nach mindestens einem der Ansprüche 1-2, dadurch gekennzeichnet, daß
der teildurchlässige Spiegel auf einer planparallelen Platte angeordnet ist.

5. Objektiv nach mindestens einem der Ansprüche 1-4, dadurch gekennzeichnet, daß
die Blendenebene (40) unter einem Winkel von 80 Grad bis 100 Grad, insbesondere 90 Grad, zur optischen Achse (A) steht.

6. Objektiv nach mindestens einem der Ansprüche 1-5, dadurch gekennzeichnet, daß
die Strahlteilerfläche (15') im Lichtweg von der Objektebene (0') zum Hohlspiegel (19') in Transmission benutzt wird.

7. Objektiv nach mindestens einem der Ansprüche 1-6, dadurch gekennzeichnet, daß
die Hauptstrahl- und Randstrahlwinkel zur optischen Achse (A) in Luft am Strahlteiler (150') kleiner als 10°, vorzugsweise kleiner als 5° sind.

8. Objektiv nach Anspruch 7, dadurch gekennzeichnet, daß die Strahlteilerfläche (15') ein Polarisations-Strahlteiler ist und zwischen ihr und dem Hohlspiegel (19') eine Lambda-Viertel-Schicht angeordnet ist.

9. Objektiv nach mindestens einem der Ansprüche 1-8, dadurch gekennzeichnet, daß
die bildseitige Apertur mindestens 0,60 vorzugsweise 0,70 ist.

10. Objektiv nach mindestens einem der Ansprüche 1-9, gekennzeichnet durch die Korrektur für Laserlicht bei einer Wellenlänge im UV- oder DUV-Bereich.

11. Objektiv nach mindestens einem der Ansprüche 1-10, dadurch gekennzeichnet, daß
innerhalb der ersten Linsengruppe (100', 200') vor dem Strahlteiler (150') ein ebener Umlenkspiegel (5') angeordnet ist.

12. Objektiv nach mindestens einem der Ansprüche 1-11, dadurch gekennzeichnet, daß alle Linsenelemente (100', 200', 300', 400') und der Strahlteiler (150') oder die Strahlteilerplatte aus dem gleichen Material gefertigt sind.

13. Objektiv nach mindestens einem der Ansprüche 1-11, dadurch gekennzeichnet, daß
alle Linsen (100', 200', 300') vor der Systemblende (40') und der Strahlteiler (150') aus Quarz, alle nachfolgenden Sammellinsen (24', 25'; 26', 27'; 28'-31', 32'-35') aus Flußspat bestehen.

14. Objektiv nach mindestens einem der Ansprüche 1-13, gekennzeichnet durch beidseitige Telezentrie.

15. Objektiv nach mindestens einem der Ansprüche 1-14, gekennzeichnet durch einen Abbildungsmaßstab im Bereich -0,5 bis -0,10, vorzugsweise rund -0,25.

16. Objektiv nach mindestens einem der Ansprüche 1 bis 15, dadurch gekennzeichnet, daß
der Abstand vom Strahlteiler (150'), bzw. der bildseitigen zur optischen Achse senkrechten Ebene, welche den Rand des Lichtbündels auf der Strahlteilerplatte in einem Punkt berührt, zur Bildebene (36') größer als das Einskommaneunfache der Brennweite der zwischen Strahlteilerfläche (15') und Bildebene (36') liegenden dritten Linsengruppe (400) ist.

17. Objektiv nach mindestens einem der Ansprüche 1-16, dadurch gekennzeichnet, daß
der Abstand vom Strahlteiler (150'), bzw. von der objektseitigen Ebene, die senkrecht zur optischen Achse ist und den Rand des Lichtbündels auf der Strahlteilerplatte in einem Punkt berührt, zur Objektebene (0') kleiner ist als die Brennweite der dazwischenliegenden ersten Linsengruppe (100', 200') .

18. Objektiv nach Anspruch 1, gekennzeichnet durch folgende Daten:
| Wellenlänge Lambda = 248,38 nm numerische Apertur NA = 0,70 Abbildungsmaßstab ß = - 0,25 Glas: Quarz n = 1,50834 | | | |
|---|---|---|---|
| Nr. | Radius | Dicke | Glas |
| | | 46,25 | |
| 1 | -208,30 | | |
| | | 11,38 | Quarz |
| 2 | -498,48 | | |
| | | 1,00 | |
| 3 | 368,29 | | |
| | | 16,30 | Quarz |
| 4 | -173,64 | | |
| | | 55,82 | |
| 5 | Plan | | |
| | | 66,00 | |
| 6 | -127,78 | | |
| | | 9,70 | Quarz |
| 7 | 251,15 | | |
| | | 79,28 | |
| 8 | 1891,95 | | |
| | | 38,73 | Quarz |
| 9 | -160,51 | | |
| | | 1,03 | |
| 10 | -2818,18 | | |
| | | 15,49 | Quarz |
| 11 | 263,13 | | |
| | | 13,96 | |
| 12 | 997,93 | | |
| | | 29,30 | Quarz |
| 13 | -273,97 | | |
| | | 1,00 | |
| 14 | Plan | | |
| | | 95,50 | Quarz |
| 15 | Plan | | |
| | | 95,50 | Quarz |
| 16 | Plan | | |
| | | 21,10 | |
| 17 | -245,27 | | |
| | | 15,63 | Quarz |
| 18 | 3216,71 | | |
| | | 15,16 | |
| 19 | -437,42 | Spiegel | |
| | | 15,16 | |
| 20 | -3216,71 | | |
| | | 15,63 | Quarz |
| 21 | 245,27 | | |
| | | 21,10 | |
| 22 | Plan | | |
| | | 191,0 | Quarz |
| 23 | Plan | | |
| | | 1,00 | |
| 24 | 278,04 | | |
| | | 24,57 | Quarz |
| 25 | 4615,58 | | |
| | | 63,39 | |
| 26 | 262,26 | | |
| | | 40,81 | Quarz |
| 27 | -620,91 | | |
| | | 1,08 | |
| 28 | 208,55 | | |
| | | 24,75 | Quarz |
| 29 | -2336,21 | | |
| | | 6,67 | |
| 30 | -441,28 | | |
| | | 15,29 | Quarz |
| 31 | 1144,28 | | |
| | | 1,06 | |
| 32 | 71,95 | | |
| | | 36,07 | Quarz |
| 33 | 50,36 | | |
| | | 13,64 | |
| 34 | 60,47 | | |
| | | 53,85 | Quarz |
| 35 | 3672,41 | | |
| | | 6,34 | |
| 36 | | | Bild (Wafer) |

19. Mikrolithographischer Projektionsapparat, dadurch gekennzeichnet, daß ein katadioptrisches Reduktionsobjektiv nach mindestens einem der Ansprüche 1-18 enthalten ist.

20. Objektiv nach mindestens einem der Ansprüche 1 bis 18, dadurch gekennzeichnet, daß die Systemblende (40') vom teildurchlässigen Spiegel (15') her gesehen vor der zweiten Linse (26', 27') der dritten Linsengruppe (400') angeordnet ist.

21. Verwendung eines Objektivs nach mindestens einem der Ansprüche 1-18 und 20 zur mikrolithographischen Projektion mit bildseitigen Strukturen im Submikronbereich.

## Claims

1. Catadioptric reducing lens
- having a first lens group (100', 200'),
- having a partially transmitting mirror (15'),
- having a second lens group (300'),
- having a concave mirror (19'), and
- having a third lens group (400') between the partially transmitting mirror (15') and the image plane (36'),
characterized in that
- the system diaphragm (40') is arranged inside the third lens group (400') downstream of the first lens (24', 25') of the third lens group (400') seen from the partially transmitting mirror (15').

2. Lens according to Claim 1, characterized in that the position of the system diaphragm (40') is fixed independently of the aperture in the range from half to the whole stop number without impairing the imaging quality.

3. Lens according to at least one of Claims 1-2, characterized in that the partially transmitting mirror (15') is arranged in a beam splitter (150').

4. Lens according to at least one of Claims 1-2, characterized in that the partially transmitting mirror is arranged on a plane-parallel plate.

5. Lens according to at least one of Claims 1-4, characterized in that the diaphragm plane (40) is at an angle of from 80 degrees to 100 degrees, in particular 90 degrees, to the optical axis (A).

6. Lens according to at least one of Claims 1-5, characterized in that the beam splitter surface (15') is used in transmission in the optical path from the object plane (0') to the concave mirror (19').

7. Lens according to at least one of Claims 1-6, characterized in that the principle ray angle and edge ray angle to the optical axis (A) in air at the beam splitter (150') are less than 10°, preferably less than 5°.

8. Lens according to Claim 7, characterized in that the beam splitter surface (15') is a polarization beam splitter, and a quarter-wave layer is arranged between said surface and the concave mirror (19').

9. Lens according to at least one of Claims 1-8, characterized in that the image-side aperture is at least 0.60, preferably 0.70.

10. Lens according to at least one of Claims 1-9, characterized by the correction for laser light at a wavelength in the UV or DUV region.

11. Lens according to at least one of Claims 1-10, characterized in that a flat deflecting mirror (5') is arranged inside the first lens group (100', 200') upstream of the beam splitter (150').

12. Lens according to at least one of Claims 1-11, characterized in that all the lens elements (100', 200', 300', 400') and the beam splitter (150') or the beam-splitter plate are manufactured from the same material.

13. Lens according to at least one of Claims 1-11, characterized in that all the lenses (100', 200', 300') upstream of the system diaphragm (40'), and the beam splitter (150') consist of quartz, and all the downstream positive lenses (24', 25'; 26', 27'; 28'-31', 32'-35') consist of fluorite.

14. Lens according to at least one of Claims 1-13, characterized by bilateral telecentricity.

15. Lens according to at least one of Claims 1-14, characterized by a reduction ratio in the range from -0.5 to -0.10, preferably approximately -0.25.

16. Lens according to at least one of Claims 1-15, characterized in that the distance from the beam splitter (150'), or the image-side plane which is perpendicular to the optical axis and touches the edge of the light bundle on the beam-splitter plate at a point, to the image plane (36') is greater than 1.9 times the focal length of the third lens group (400) lying between the beam-splitter surface (15') and image plane (36').

17. Lens according to at least one of Claims 1-16, characterized in that the distance from the beam splitter (150'), or from the object-side plane which is perpendicular to the optical axis and touches the edge of the light bundle on the beam-splitter plate at a point, to the object plane (0') is smaller than the focal length of the first lens group (100', 200') situated therebetween.

18. Lens according to Claim 1, characterized by the following data:
| Wavelength lambda = 248.38 nm Numerical aperture NA = 0.70 Reduction ratio ß = - 0.25 Glass: Quartz n = 1.50834 | | | |
|---|---|---|---|
| No. | Radius | Thickness | Glass |
| | | 46.25 | |
| 1 | -208.30 | | |
| | | 11.38 | Quartz |
| 2 | -498.48 | | |
| | | 1.00 | |
| 3 | 368.29 | | |
| | | 16.30 | Quartz |
| 4 | -173.64 | | |
| | | 55.82 | |
| 5 | Plane | | |
| | | 66.00 | |
| 6 | -127.78 | | |
| | | 9.70 | Quartz |
| 7 | 251.15 | | |
| | | 79.28 | |
| 8 | 1891.95 | | |
| | | 38.73 | Quartz |
| 9 | -160.51 | | |
| | | 1.03 | |
| 10 | -2818.18 | | |
| | | 15.49 | Quartz |
| 11 | 263.13 | | |
| | | 13.96 | |
| 12 | 997.93 | | |
| | | 29.30 | Quartz |
| 13 | -273.97 | | |
| | | 1.00 | |
| 14 | Plane | | |
| | | 95.50 | Quartz |
| 15 | Plane | | |
| | | 95.50 | Quartz |
| 16 | Plane | | |
| | | 21.10 | |
| 17 | -245.27 | | |
| | | 15.63 | Quartz |
| 18 | 3216.71 | | |
| | | 15.16 | |
| 19 | -437.42 | Mirror | |
| | | 15.16 | |
| 20 | -3216.71 | | |
| | | 15.63 | Quartz |
| 21 | 245.27 | | |
| | | 21.10 | |
| 22 | Plane | | |
| | | 191.0 | Quartz |
| 23 | Plane | | |
| | | 1.00 | |
| 24 | 278.04 | | |
| | | 24.57 | Quartz |
| 25 | 4615.58 | | |
| | | 63.39 | |
| 26 | 262.26 | | |
| | | 40.81 | Quartz |
| 27 | -620.91 | | |
| | | 1.08 | |
| 28 | 208.55 | | |
| | | 24.75 | Quartz |
| 29 | -2336.21 | | |
| | | 6.67 | |
| 30 | -441.28 | | |
| | | 15.29 | Quartz |
| 31 | 1144.28 | | |
| | | 1.06 | |
| 32 | 71.95 | | |
| | | 36.07 | Quartz |
| 33 | 50.36 | | |
| | | 13.64 | |
| 34 | 60.47 | | |
| | | 53.85 | Quartz |
| 35 | 3672.41 | | |
| | | 6.34 | |
| 36 | | | Image (wafer) |

19. Microlithographic projection apparatus, characterized in that a catadioptric reducing lens according to at least one of Claims 1-18 is present.

20. Lens according to at least one of Claims 1 to 18, characterized in that the system diaphragm (40') is arranged upstream of the second lens (26', 27') of the third lens group (400') seen from the partially transmitting mirror (15').

21. Use of a lens according to at least one of Claims 1-18 and 20 for a microlithographic projection with image-side structures in the submicron range.

## Revendications

1. Objectif réducteur catadioptrique, comprenant :
- un premier groupe de lentilles (100', 200'),
- un miroir partiellement transparent (15'),
- un deuxième groupe de lentilles (300'),
- un miroir concave (19'),
- un troisième groupe de lentilles (400') entre le miroir partiellement transparent (15') et le plan focal (36'),
caractérisé en ce que :
- le diaphragme système (40') est agencé à l'intérieur du troisième groupe de lentilles (400'), observé à partir du miroir partiellement transparent (15'), derrière la première lentille (24', 25') du troisième groupe de lentilles (400').

2. Objectif selon la revendication 1, caractérisé en ce que la position du diaphragme système (40') est fixe, indépendamment de l'ouverture, dans la zone de la demi-valeur à la valeur complète du diaphragme, sans porter préjudice à la qualité de l'image.

3. Objectif selon au moins l'une des revendications 1-2, caractérisé en ce que le miroir partiellement transparent (15') est agencé dans un répartiteur de faisceau (150').

4. Objectif selon au moins l'une des revendications 1-2, caractérisé en ce que le miroir partiellement transparent est agencé sur une plaque plan-parallèle.

5. Objectif selon au moins l'une des revendications 1-4, caractérisé en ce que le plan (40) du diaphragme fait un angle de 80° à 100°, en particulier de 90°, avec l'axe optique (A).

6. Objectif selon au moins l'une des revendications 1-5, caractérisé en ce que la surface de répartiteur de faisceau (15') est utilisée dans le trajet lumineux du plan objet (0') au miroir concave (19') pour la transmission.

7. Objectif selon au moins l'une des revendications 1-6, caractérisé en ce que l'angle du faisceau principal et l'angle du faisceau de bord par rapport à l'axe optique (A) sont plus petits que 10°, de préférence plus petits que 5°, dans l'air sur le répartiteur de faisceau (150').

8. Objectif selon la revendication 7, caractérisé en ce que la surface (15') du répartiteur de faisceau est un répartiteur de faisceau à polarisation et une couche quart d'onde lambda est agencée entre celui-ci et le miroir concave (19').

9. Objectif selon au moins l'une des revendications 1-8, caractérisé en ce que l'ouverture côté image est d'au moins 0,60, de préférence de 0,70.

10. Objectif selon au moins l'une des revendications 1-9, caractérisé par la correction de la lumière laser à une longueur d'onde dans la plage des UV ou des DUV.

11. Objectif selon au moins l'une des revendications 1-10, caractérisé en ce qu'un miroir de déviation plan (5') est agencé dans le premier groupe de lentilles (100', 200') devant le répartiteur de faisceau (150').

12. Objectif selon au moins l'une des revendications 1-11, caractérisé en ce que tous les éléments de lentille (100', 200', 300', 400') et le répartiteur de faisceau (150') ou la plaque du répartiteur de faisceau sont constitués du même matériau.

13. Objectif selon au moins l'une des revendications 1-11, caractérisé en ce que toutes les lentilles (100', 200', 300') situées devant le diaphragme système (40') et le répartiteur de faisceau (150') sont constitués de quartz et toutes les lentilles convexes suivantes (24', 25'; 26', 27'; 28'-31', 32'-35') sont constituées de spath fluor.

14. Objectif selon au moins l'une des revendications 1-13, caractérisé par un aménagement télécentrique des deux côtés.

15. Objectif selon au moins l'une des revendications 1-14, caractérisé par une échelle de formation d'image dans la plage de -0,5 à -0,10, de préférence aux environs de -0,25.

16. Objectif selon au moins l'une des revendications 1 à 15, caractérisé en ce que la distance entre le répartiteur de faisceau (150') ou selon le cas le plan côté image perpendiculaire à l'axe optique, qui vient en contact avec le bord du faisceau lumineux sur la plaque du répartiteur de faisceau en un point, et le plan image (36') est plus grande que 1,9 fois la distance focale du troisième groupe de lentilles (400) disposé entre la surface (15') du répartiteur de faisceau et le plan image (36').

17. Objectif selon au moins l'une des revendications 1-16, caractérisé en ce que la distance entre le répartiteur de faisceau (150') ou selon le cas du plan côté objet, qui est perpendiculaire à l'axe optique et vient en contact avec le bord du faisceau lumineux sur la plaque du répartiteur de faisceau en un point, et le plan objet (0') est plus petite que la distance focale du premier groupe de lentilles (100', 200') qui se trouve entre eux.

18. Objectif selon la revendication 1, caractérisé par les données suivantes :
| Longueur d'onde lambda = 248,38 nm | | | Ouverture numérique NA = 0,70 |
|---|---|---|---|
| Echelle de formation d'image β = -0,25 | | | Verre : quartz n = 1,50834 |
| N° | Rayon | Epaisseur | Verre |
| 1 | -208,30 | 46,25 | |
| 2 | -498,48 | 11,38 | Quartz |
| 3 | 368,29 | 1,00 | |
| 4 | -173,64 | 16,30 | Quartz |
| 5 | Plan | 55,82 | |
| 6 | -127,78 | 66,00 | |
| 7 | 251,15 | 9,70 | Quartz |
| 8 | 1891,95 | 79,28 | |
| 9 | -160,51 | 38,73 | Quartz |
| 10 | -2818,18 | 1,03 | |
| 11 | 263,13 | 15,49 | Quartz |
| 12 | 997,93 | 13,96 | |
| 13 | -273,97 | 29,30 | Quartz |
| 14 | Plan | 1,00 | |
| 15 | Plan | 95,50 | Quartz |
| 16 | Plan | 95,50 | Quartz |
| 17 | -245,27 | 21,10 | |
| 18 | 3216,71 | 15,63 | Quartz |
| 19 | -437,42 | 15,16 | |
| | | Miroir | |
| | | 15,16 | |
| 20 | -3216,71 | 15,63 | Quartz |
| 21 | 245,27 | 21,10 | |
| 22 | Plan | 191,0 | Quartz |
| 23 | Plan | 1,00 | |
| 24 | 278,04 | 24,57 | Quartz |
| 25 | 4615,58 | 63,39 | |
| 26 | 262,26 | 40,81 | Quartz |
| 27 | -620,91 | 1,08 | |
| 28 | 208,55 | 24,75 | Quartz |
| 29 | -2336,21 | 6,67 | |
| 30 | -441,28 | 15,29 | Quartz |
| 31 | 1144,28 | 1,06 | |
| 32 | 71,95 | 36,07 | Quartz |
| 33 | 50,36 | 13,64 | |
| 34 | 60,47 | 53,85 | Quartz |
| 35 | 3672,41 | 6,34 | |
| 36 | | | Image (pastille) |

19. Appareil de projection microlithographique caractérisé en ce qu'il contient un objectif réducteur catadioptrique selon au moins l'une des revendications 1-18.

20. Objectif sselon au moins l'une des revendications 1 à 18, caractérisé en ce que le diaphragme système (40') observé à partir du miroir partiellement transparent (15') est agencé devant la seconde lentille (26', 27') du troisième groupe de lentilles (400').

21. Utilisation d'un objectif selon au moins l'une des revendications 1-18 et 20 pour la projection microlithographique avec des structures côté image dans le domaine en dessous du micron.
